# EUROPÄISCHE PATENTSCHRIFT

(11) **EP 0 513 570 B1**
(45) Veröffentlichungstag und Bekanntmachung des Hinweises auf die Patenterteilung: **10.01.1996**
(21) Anmeldenummer: 92106913.4
(22) Anmeldetag: 23.04.1992
(51) Int. Cl.: H05K 13/08

(54) **Einrichtung zum Prüfen des Vorhandenseins von Setzstiften in einer Leiterplatte beim automatischen Einsetzen der Setzstifte**
Equipment for checking the presence of pins in a printed wiring board when automatically mounting the pins
Dispositif pour vérifier l'existence de broches dans une plaquette de circuits imprimés lors de l'insertion automatique de broches

(30) Priorität: 15.05.1991 DE 4115782
(43) Veröffentlichungstag der Anmeldung: 19.11.1992
(73) Patentinhaber: GRUNDIG E.M.V. Elektro-Mechanische Versuchsanstalt Max Grundig GmbH & Co. KG, D-90762 Fürth (DE)
(72) Erfinder: Gillinger, Günther, Grundig E.M.V. Max Grundig, W-8510 Fürth (DE)

(56) Entgegenhaltungen:
- DE-A- 2 510 679
- DE-A- 3 618 570
- DE-B- 2 530 750

## Beschreibung

Die Erfindung betrifft eine Einrichtung zum Prüfen des Vorhandenseins von Setzstiften in einer Leiterplatte beim automatischen Einsetzen der Setzstifte gemäß dem Oberbegriff des Anspruchs 1.

Leiterplatten werden heute in fast allen Fällen vollautomatisch bestückt. Die Zuführung, Positionierung, Befestigung usw. der Bauteile, wie Widerstände, Kondensatoren, Transistoren, integrierte Schaltbausteine usw. wird von Bestückungsautomaten bewerkstelligt. Bauteile, die dazu in Löcher in der Leiterplatte eingesetzt werden, haben dünnere Anschlußdrähte als die Durchmesser der Leiterplattenlöcher. Das Durchstecken der Anschlußdrähte durch die Leiterplatte erfolgt also nahezu kraftlos. Außer den erwähnten, üblichen Bauteilen, müssen in viele Leiterplatten auch noch sogenannte Setzstifte zur Schaffung von Steckanschlüssen eingebracht werden. Diese Setzstifte müssen in der Leiterplatte fest sitzen, senkrecht zur Leiterplatte und parallel zueinander stehen und werden deshalb eingepresst. Dazu ist eine einwandfreie Zuordnung des Setzstiftes zur Leiterplattenbohrung, sowie eine einwandfreie Geometrie des Setzstiftes notwendig, damit er von der Zuführeinrichtung sicher gefasst und ebenso sicher über das Loch in der Leiterplatte gebracht werden kann. Ist eine der Voraussetzungen nicht erfüllt, kann es vorkommen, daß eine Fehlbestückung erfolgt, d.h. der Setzstift wird nicht in die Leiterplatte eingesetzt. Erfahrungsgemäß ist dies bei ca. 4% der zu bestückenden Leiterplatten der Fall. Fehlen also Setzstifte in der bestückten Leiterplatte, so müssen sie meist in der fertigen Leiterplatte durch Nacharbeit kostenaufwendig nachbestückt werden. Um diese Nacharbeit zu vermeiden, ist es erforderlich, das Vorhandensein des einzelnen Setzstiftes unmittelbar nach seinem Bestückungsvorgang zu prüfen. Wird eine Fehlbestückung, d.h. das Nichtvorhandensein eines Setzstiftes festgestellt, so kann dieser Mangel durch Wiederholung des Einpressvorganges sofort behoben werden.

Für eine solche Prüfung sind bereits Prüfeinrichtungen bekannt und üblich, die auf mechanischem oder optischem Weg arbeiten ( siehe z.B. DE-B-2 530 750). Leider sind beide Verfahren selbst wieder störanfällig durch Verschmutzung. Gerade aber beim Einpressen der Setzstifte in die Leiterplatte entsteht Leiterplatten- und Metallabrieb, da die Löcher in der Leiterplatte kleiner als die Durchmesser der Setzstifte an ihrem Einpressende sind. Dieser Abrieb kann nun zu der die Funktion der Prüfeinrichtung negativ beeinflussenden Verschmutzung führen.

Aufgabe der Erfindung ist es, eine Einrichtung zu schaffen, die eine einwandfreie Prüfung des Vorhandenseins von Setzstiften in einer Leiterplatte unmittelbar nach dem Einpressvorgang des einzelnen Setzstiftes ermöglicht und dabei eine eventuell auftretende Verschmutzung, wie sie beispielsweise durch Leiterplatten- und Metallabrieb auftritt, beseitigt.

Diese Aufgabe wird durch die im Anspruch 1 gekennzeichneten Merkmale gelöst. Vorteilhafte Ausgestaltungen werden in den Unteransprüchen beschrieben.

So ist in Anspruch 2 eine relativ preisgünstige und störunanfällige Differenzdruck-Meßeinrichtung vorgeschlagen, die das Vorhanden- oder Nichtvorhandensein des Setzstiftes in der Leiterplatte feststellt.

Im Anspruch 3 ist beidseitig der Differenzdruck-Meßeinrichtung eine Druckluftzufuhr beschrieben. Damit kann die Meßzeit erheblich verkürzt werden.

Die Ansprüche 4 und 5 beschreiben die Weiterbehandlung des von der Differenzdruck-Messeinrichtung gewonnenen Meßsignals auf elektronischem bzw. pneumatischem Weg.

Die Erfindung wird nun nachstehend anhand der Zeichnungen näher erläutert.
- Fig. 1: zeigt die erfindungsgemäße Einrichtung in einer ersten Ausführungsform.
- Fig. 2: zeigt eine zweite Ausführungsform der Erfindung, bei der zusätzlich zur ersten Ausführungsform ein zweiter Druckluftanschluß vorhanden ist.
- Fig. 3: zeigt die zweite Ausführungsform in Arbeitsstellung nach erfolgtem Einpressen eines Setzstiftes in die Leiterplatte.
- Fig. 4: gibt den Zustand aus Fig. 3 wieder, wenn eine Fehlbestückung vorliegt, d.h. wenn kein Setzstift eingepresst wurde.

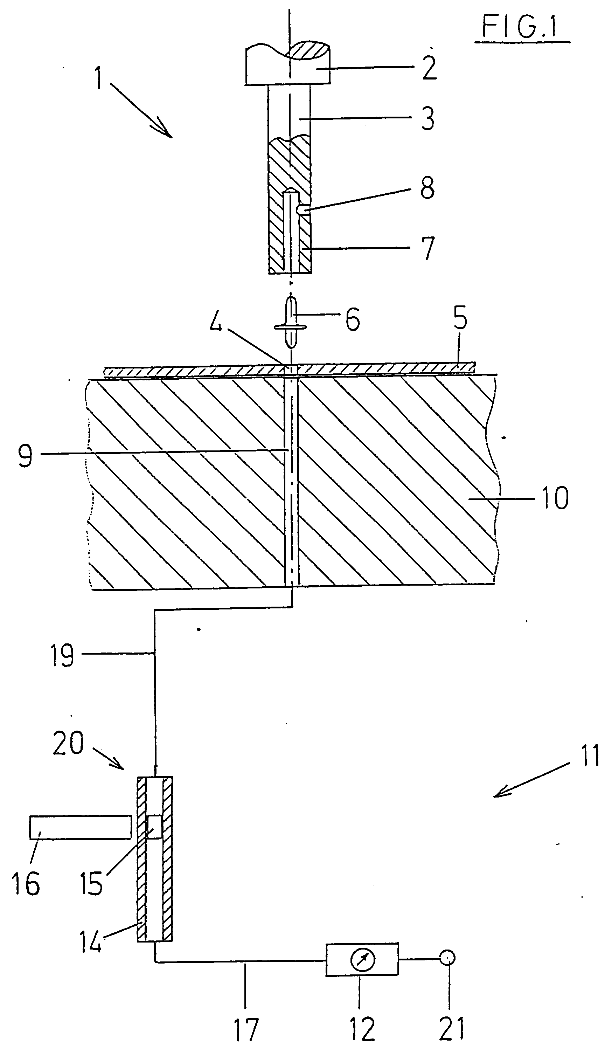

Die erste Ausführungsform der erfindungsgemäßen Einrichtung 1 nach Fig. 1 besteht aus einer Setzspindel 2 mit einem Setzstempel 3, einem Unterwerkzeug 10, einer pneumatischen Einrichtung 11 und einer Differenzdruck-Meßeinrichtung 20. Die gezeigte Einrichtung befindet sich in einem Betriebszustand, in dem der Setzstift 6 von einer - hier nicht gezeigten - Zuführeinrichtung über der Leiterplattenbohrung 4 der Leiterplatte 5 positioniert ist. Von einem Druckluftanschluß 21 fließt Druckluft über ein Druckminderventil 12 und wird auf einen Druck P1 reduziert. Durch die Leitung 17 gelangt die Druckluft zu einem Rohr 14, in dem sich ein Metallkörper 15 befindet. Außerhalb des Rohres ist ein induktiver Sensor 16 angebracht, der auf den Metallkörper 15 im Rohr reagiert. In dem gezeigten Betriebszustand wird der Metallkörper 15 von der Druckluft mit dem Druck P1 so angehoben, daß er in der Höhe des induktiven Sensors steht. Das Rohr 14 ist mit seinem zweiten Ende über eine Leitung 19 mit einer Bohrung 9 des Unterwerkzeugs 10 verbunden. Die zwischen dem Metallkörper und der inneren Rohrwandung vorbeiströmende Luft tritt am Oberteil des Unterwerkzeuges 10 aus und bläst dort eventuell sich befindliche Schmutzpartikel weg. Der induktive Sensor 16 reagiert auf das Vorhandensein des Metallkörpers 15 und stellt fest, daß in die Leiterplatte 5 kein Setzstift 6 eingepresst ist. Dies führt jedoch zu keiner Fehlermeldung, da sich die Setzspindel 2 in ihrer oberen Lage befindet und deshalb kein eingepresster Setzstift 6 erwartet wird. Der Prüfvorgang erfolgt nur dann, wenn sich die Setzspindel 2 in ihrer unteren, der Arbeitslage befindet.

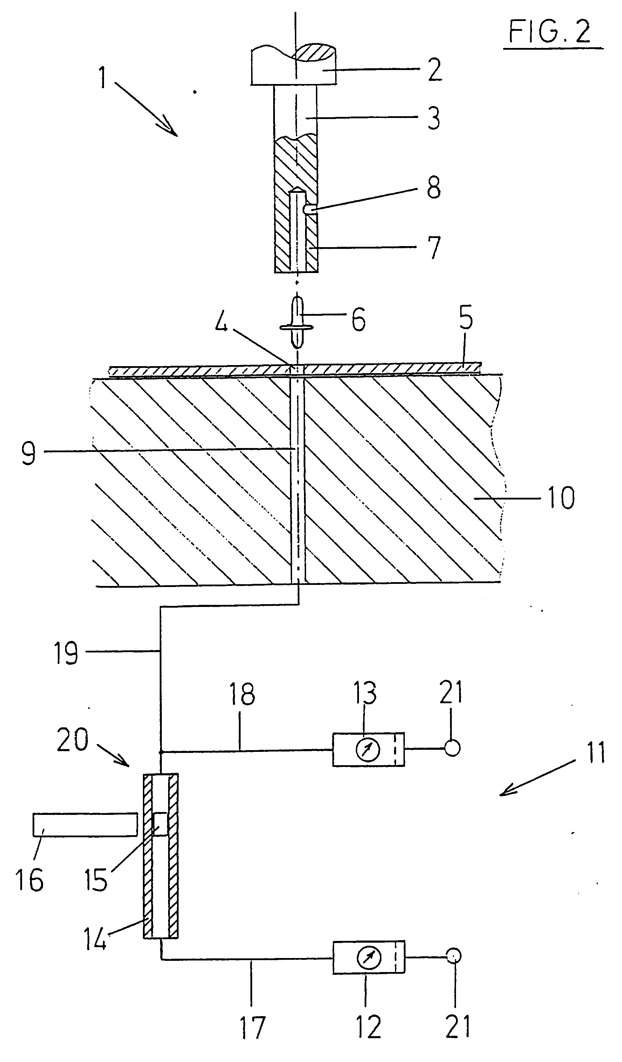

In einer zweiten Ausführungsform nach Fig. 2 ist am Ausgang des Rohres 14 eine zweite Leitung 18 angeschlossen, die vom Druckluftanschluß 21 über ein zweites Druckminderventil 13 mit Druckluft mit einem Druck P2 beaufschlagt wird. Der Druck P2 ist kleiner als der Druck P1. Beide Drücke sind so aufeinander abgestimmt, daß sich der Metallkörper 15 beim Nichtvorhandensein eines Setzstiftes 6 in der gezeichneten Lage, also gegenüber dem induktiven Sensor 16 befindet. Der Luftstrom durch die Leitung 19 und die Bohrung 9 wird gegenüber der Ausführungsform 1 verstärkt und damit auch die Reinigungswirkung am Bohrungsausgang von Bohrung 9.

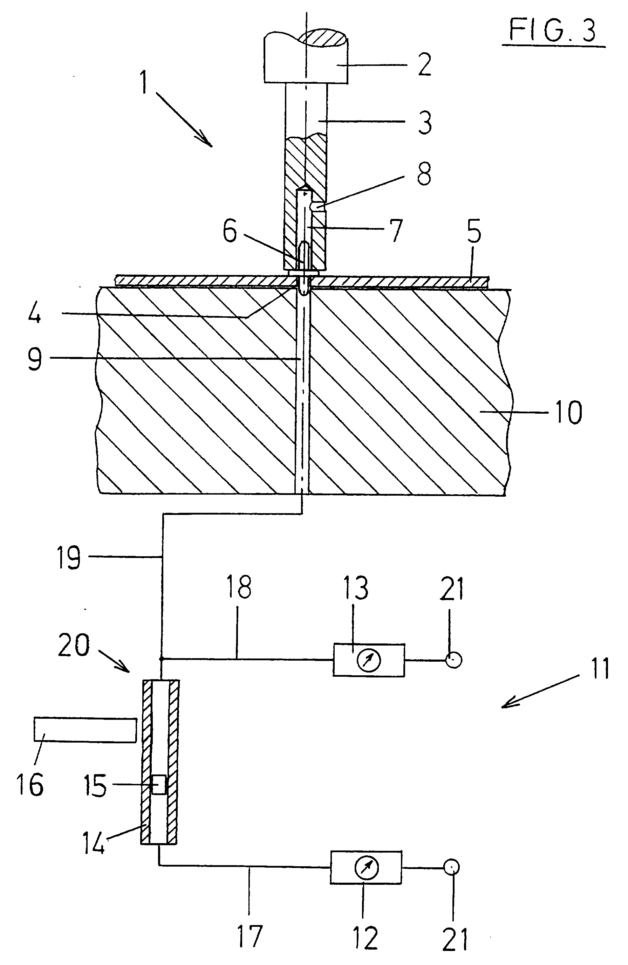

In Fig. 3 ist die zweite Ausführungsform gezeigt, jedoch im Betriebszustand mit eingepresstem Setzstift 6. Durch den die Bohrung 9 abdichtenden Setzstift 6 entsteht nun zwischen dem Setzstift und dem Ausgang des Rohres 14 ein Staudruck, der dazu führt, daß der Metallkörper 15 im Rohr 14 nach unten verschoben wird und somit aus dem Erfassungsbereich des induktiven Sensors 16 gelangt. Der Staudruck baut sich in der hier beschriebenen zweiten Ausführungsform durch das Vorhandensein eines zweiten Druckluftanschlusses 13, 18, 21 sehr schnell auf. Das führt zu einer schnellen Reaktion der Differenzdruck-Meßeinrichtung 20 und damit zu einer kurzen Meßzeit. Die in ihrer unteren Lage sich befindliche Setzspindel 2 löst nun den Prüfvorgang aus. Die Differenzdruck-Meßeinrichtung 20 signalisiert das Vorhandensein eines Setzstiftes 6 und die Setzspindel 2 kann zur Vorbereitung des nächsten Setzstift-Einpressvorgangs in ihre obere Lage zurückfahren.

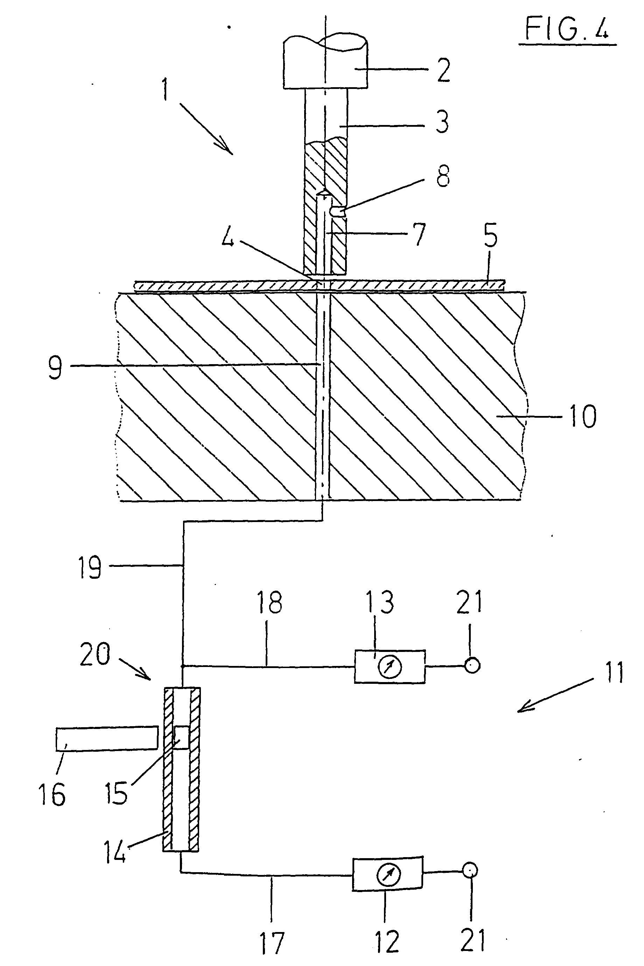

In Fig. 4 ist der gleiche Betriebszustand der Einrichtung wie in Fig. 3 gezeigt, nur daß hier kein Setzstift eingepresst wurde. Es liegt also eine Fehlbestückung vor. Der Ausgang der Bohrung 9 wird nun nicht abgedichtet. Die Druckluft strömt in die Bohrung 7 des Setzstempels 3 und verläßt diesen wieder durch eine Querbohrung 8. Da sich also in diesem Fall kein Staudruck in der Bohrung 9 und der Leitung 19 aufbaut, bleibt der Metallkörper 15 in dem Erfassungsbereich des induktiven Sensors 16 stehen. Die Setzspindel 2 befindet sich in ihrer unteren Lage, folglich wird ein Prüfvorgang eingeleitet. Die Differenzdruck-Meßeinrichtung 20 signalisiert, daß kein Setzstift 6 vorhanden ist, was zu einer entsprechenden Reaktion der Steuerung der Einrichtung 1 führt, auf die jedoch hier nicht näher eingegangen wird.

## Patentansprüche

1. Einrichtung (1) zum Prüfen des Vorhandenseins von Setzstiften (6) in einer Leiterplatte (5) beim automatischen Einsetzen der Setzstifte mittels einer Stiftsetzmaschine, wobei die Einrichtung (1) aus einem Unterwerkzeug (10), einer Leiterplatten-Aufnahme und -Führungseinrichtung, sowie einer Setzspindel (2) mit Setzstempel (3) besteht,
**dadurch gekennzeichnet,**daß
- das Unterwerkzeug (10) eine Bohrung (9) aufweist, die leiterplattenseitig konzentrisch zum einzusetzenden Setzstift (6) endet,
- der Setzstempel (3) eine den Setzstift (6) aufnehmende Bohrung und eine nach außen führende Querbohrung (8) besitzt,
- mittels einer pneumatischen Einrichtung (11) Druckluft über die Leitung (19) in die Bohrung (9) gefördert wird,
- die pneumatische Einrichtung (11) eine Differenzdruck-Meßeinrichtung (20), mindestens eine Druckluftzuleitung (17) mit vorgeschaltetem Druckwandler (12) und einen Druckluftanschluß (21) besitzt, wobei die Differenzdruck-Meßeinrichtung (20) zur Überprüfung, ob sich in der Bohrung (9) und der Leitung (19) ein Standruck aufbaut, vorgesehen ist.

2. Einrichtung nach Anspruch 1,
**dadurch gekennzeichnet**, daß
die Differenzdruck-Meßeinrichtung (20) aus einem Rohr (14) mit einem Metallbolzen (15) und einem Sensor (16) besteht.

3. Einrichtung nach den Ansprüchen 1 und 2,
**dadurch gekennzeichnet**, daß
an beiden Enden der Differenzdruck-Meßeinrichtung (20) eine Druckluftzufuhr (17, 18) mit jeweiligem Druckwandler (12, 13) angeschlossen ist.

4. Einrichtung nach den Ansprüchen 1 und 2,
**dadurch gekennzeichnet**, daß
das von der Differenzdruck-Meßeinrichtung (20) erzeugte Meßsignal elektronisch ausgewertet und zur Steuerung der Einrichtung (1) verwendet wird.

5. Einrichtung nach den Ansprüchen 1 und 2,
**dadurch gekennzeichnet**, daß
das von der Differenzdruck-Meßeinrichtung (20) erzeugte Meßsignal pneumatisch ausgewertet und zur Steuerung der Einrichtung (1) verwendet wird.

## Claims

1. Device (1) for testing for the presence of press-fit pins (6) in a printed circuit board (5) in the automatic insertion of press-fit pins by means of a pin press-fitting machine, the device (1) comprising a lower tool (10), a printed-circuit-board receptacle and guide device, and also a press-fitting spindle (2) with press-fitting plunger (3), characterized in that
- the lower tool (10) has a bore (9) which terminates on the printed-circuit-board side concentrically with the press-fit pin (6) to be inserted,
- the press-fitting plunger (3) has a bore which receives the press-fit pin (6) and a transverse bore (8) which leads outwards,
- compressed air is pumped into the bore (9) via the line (19) by means of a pneumatic device (11),
- the pneumatic device (11) has a differential pressure measuring device (20), at least one compressed-air supply line (17) with upstream pressure converter (12) and a compressed-air connection (21), the differential pressure measuring device (20) being provided to check whether a back pressure builds up in the bore (9) and the line (19) .

2. Device according to Claim 1, characterized in that the differential pressure measuring device (20) comprises a tube (14) with a metal bolt (15) and a sensor (16).

3. Device according to Claims 1 and 2, characterized in that a compressed-air supply (17, 18) with associated pressure converter (12, 13) is connected to both ends of the differential pressure measuring device (20).

4. Device according to Claims 1 and 2, characterized in that the measurement signal generated by the differential pressure measuring device (20) is evaluated electronically and is used to control the device (1).

5. Device according to Claims 1 and 2, characterized in that the measurement signal generated by the differential pressure measuring device (20) is evaluated pneumatically and is used to control the device (1).

## Revendications

1. Dispositif (1) pour contrôler la présence de broches de positionnement (6) dans une plaquette à circuits imprimés (5) lors de l'insertion automatique des broches de positionnement à l'aide d'une machine de positionnement de broches, le dispositif (1) étant constitué par un outil sous-jacent (10), un logement et un dispositif de guidage de plaquette à circuits imprimés ainsi qu'une broche de positionnement (2) comportant un poinçon de positionnement (3),
caractérisé par le fait que
- l'outil sous-jacent (10) possède un perçage (9) qui se termine, du côté de la plaquette à circuits imprimés, concentriquement autour de la broche de positionnement (6) devant être insérée,
- le poinçon de positionnement (3) possède un perçage qui loge la tige de positionnement (6), et un perçage transversal (8) qui débouche à l'extérieur,
- à l'aide d'un dispositif pneumatique (11), de l'air comprimé est introduit dans le perçage (2) par l'intermédiaire de la canalisation (19),
- le dispositif pneumatique (11) possède un dispositif (20) de mesure de la pression différentielle, au moins une canalisation (17) d'amenée d'air comprimé comportant un transducteur de pression (12) branché en amont, et un raccord à air comprimé (21), le dispositif (20) de mesure de pression différentielle étant destiné à contrôler si une pression dynamique s'établit dans le perçage (9) et dans la canalisation (19).

2. Dispositif selon la revendication 1, caractérisé en ce que le dispositif (20) de mesure de pression différentielle est constitué par un tube (14) possédant un boulon métallique (15) et un capteur (16).

3. Dispositif selon les revendications 1 et 2, caractérisé en ce qu'aux deux extrémités du dispositif (20) de mesure de pression différentielle est raccordée une alimentation d'air comprimé (17,18) équipée d'un transducteur de pression respectif (12,13).

4. Dispositif selon les revendications 1 et 2, caractérisé en ce que le signal de mesure produit par le dispositif (20) de mesure de pression différentielle est évalué par voie électronique et est utilisé pour la commande du dispositif (1).

5. Dispositif selon les revendications 1 et 2, caractérisé en ce que le signal de mesure produit par le dispositif (20) de mesure de la pression différentielle est évalué pneumatiquement et est utilisé pour la commande du dispositif (1).
